# EUROPÄISCHE PATENTSCHRIFT

(11) **EP 1 348 781 B1**
(45) Veröffentlichungstag und Bekanntmachung des Hinweises auf die Patenterteilung: **15.12.2004**
(21) Anmeldenummer: 03405135.9
(22) Anmeldetag: 28.02.2003
(51) Int. Cl.: C30B 11/00, C30B 11/04, B23K 26/00

(54) **Verfahren zum epitaktischen Wachstum mit energetischem Strahl**
Methode de croissance épitaxiale par irradiation avec un faisceau d'énergie
Method for epitaxial growth by energetic beam irradiation

(30) Priorität: 26.03.2002 EP 02405238
(43) Veröffentlichungstag der Anmeldung: 01.10.2003
(73) Patentinhaber: Sulzer Markets and Technology AG, 8401 Winterthur (CH)
(72) Erfinder: Betz, Jürgen, Dr., 55583 Bad Münster-Ebernburg (DE)
(74) Vertreter: Sulzer Management AG

(56) Entgegenhaltungen:
- EP-A- 0 892 090
- PATENT ABSTRACTS OF JAPAN vol. 012, no. 392 (M-755), 19. Oktober 1988 (1988-10-19) & JP 63 140787 A (KOMATSU LTD), 13. Juni 1988 (1988-06-13)
- PATENT ABSTRACTS OF JAPAN vol. 012, no. 031 (M-663), 29. Januar 1988 (1988-01-29) & JP 62 183986 A (NIPPON KOKAN KK), 12. August 1987 (1987-08-12)

## Beschreibung

Die Erfindung betrifft ein Verfahren zum Einkristallschweissen gemäss dem Oberbegriff des unabhängigen Anspruchs 1, sowie die Verwendung des Verfahrens zur Ergänzung einer einkristallinen Oberflächenstruktur eines abgenutzten einkristallinen Substrats.

Es ist bekannt, mechanisch, chemisch und thermisch hoch belastete metallische Werkstücke nicht in klassischen Giessprozessen herzustellen, sondern in Form von Einkristallen aus der metallischen Schmelze zu züchten. Dabei kommen wohlbekannte Verfahren (die in geeigneter Weise modifiziert sein können), wie beispielsweise das Verfahren nach Bridgman zum Einsatz. Das heisst, das Werkstück wird in der gewünschten Form kontrolliert durch gerichtetes Erstarren aus einer Metallschmelze gewonnen.

Wenn in der vorliegenden Schrift von Einkristallen oder einkristallinen Bereichen, Schichten oder Strukturen die Rede ist, sind damit Einkristalle umfasst, die keine Korngrenzen oder höchstens Kleinwinkelkorngrenzen von weniger als 10° aufweisen. Damit können unter den zuvor genannten Begriffen auch sogenannte "gerichtet erstarrte Strukturen" (directionally solidified structures) verstanden werden. Dabei handelt es sich um Einkristallstrukturen, die Korngrenzen aufweisen, die jedoch im wesentlichen parallel, d.h. nur in eine Richtung verlaufen.

Solche metallischen Werkstücke mit einkristalliner Struktur werden bevorzugt als Maschinenkomponenten verwendet, die über längere Zeiträume hohen Temperaturen und starken mechanischen oder chemischen Belastungen ausgesetzt sind. So kann beispielsweise in der Regel die Schmelztemperatur der einkristallinen Strukturen deutlich gegenüber der Schmelztemperatur eines entsprechenden, aus dem gleichen Material hergestellten, polykristallinen Werkstücks erhöht werden. Zudem ist in den einkristallinen Werkstücken der Schmelzpunkt deutlich schärfer definiert.

Daher eignen sich einkristalline Maschinenteile z.B. besonders zum Einsatz als Schaufeln von Gasturbinen oder als Rotoren für Flugzeugtriebwerke. Als Legierungen für solche einkristallinen Turbinenschaufeln haben sich sogenannte "Superlegierungen", z.B. auf Nickel (Ni), Kobalt (Co) oder Eisenbasis (Fe) bewährt. Besonders Superlegierungen auf Nickelbasis wie beispielsweise CMSX-2 oder CMSX-4 zeigen hervorragende mechanische, chemische und thermische Eigenschaften, selbst bei hohen Temperaturen, nur wenig unterhalb ihres Schmelzpunktes.

Trotz der zuvor geschilderten hohen Widerstandsfähigkeit solcher einkristallinen Maschinenteile, tritt im Betrieb aufgrund der hohen Belastungen mit der Zeit ein gewisser Verschleiss der Oberflächen auf. Das heisst im Betrieb können sich auf der Oberfläche solcher Maschinenteile z.B. Nuten, abgesetzte Stufen, Einbuchtungen oder Schäden anderer Art einstellen. Es kann sogar vorkommen, dass z.B. durch Reibung oder andere Verschleissprozesse, z.B. chemischer oder thermischer Art, ganze Oberflächenbereiche grossflächig abgetragen werden, so dass die entsprechenden Maschinenteile entweder ersetzt oder deren beschädigte Oberflächen wiederhergestellt werden müssen. Da die Herstellung kompletter Werkstücke in aufwendigen Einkristall-Züchtungsverfahren sehr kostenintensiv ist, ist man bestrebt, durch geeignete Reparaturverfahren die beschädigten Oberflächen wiederherzustellen.

Dabei muss die Wiederherstellung (Rekonditionierung), also die Reparatur der Oberflächen, durch den Neuaufbau einkristalliner Schichten bzw. durch eine Ergänzung einkristalliner Bereiche erfolgen. Das heisst, auf dem Substrat, z.B. einer einkristallinen Turbinenschaufel, wird in den beschädigten Bereichen Schicht für Schicht einkristallin (vorzugsweise mit dem gleichen Material, aus dem das Substrat besteht) die ursprüngliche Struktur wieder aufgebaut. Dabei muss die Kristallstruktur des Substrats möglichst ohne Korngrenzen fortgesetzt werden. Derartige Verfahren werden im Rahmen dieser Anmeldung mit dem Begriff "Einkristallschweissen" bezeichnet.

Aus der EP 0 861 927 A1 ist ein Verfahren zum Einkristallschweissen bekannt, mit welchem es möglich ist, auf der einkristallinen Struktur eines Substrats eine oder mehrere Schichten, bzw. einen Körper oder ein Werkstück mit einkristalliner Struktur aufzubauen. Bei diesem Verfahren handelt es sich um ein epitaktisches Verfahren, d.h. die kristalline Struktur des Substrats wird von der Schicht, die darauf aufgebaut wird, übernommen. Allgemein versteht man unter Epitaxie bzw. unter epitaktischem Wachstum das orientierte Kristallwachstum, insbesondere auf einer einkristallinen Unterlage, d.h. auf einem Substrat. Als Energie- oder Wärmequellen für die Durchführung dieses Verfahrens kommen unter anderem beispielsweise Laserstrahlen in Frage, mit denen es möglich ist, auf eine sehr kleine Fläche hohe Energiemengen konzentriert einzubringen. Bei dem in der EP 0 861 927 A1 gezeigten Verfahren wird ein Strahl hoher Energie und Energiedichte konzentriert auf die Oberfläche des Substrats gerichtet, so dass die Oberflächenschicht des Substrats leicht anschmilzt. Dem Arbeitsbereich des konzentrierten Strahls wird das notwendige Material zur Rekonstruktion der Oberfläche in Form eines Drahtes oder in Form von Pulver zugeführt und ebenfalls von dem Energiestrahl geschmolzen. Durch geeignete Wahl der Prozessparameter kann durch das bekannte Verfahren zum Einkristallschweissen erreicht werden, dass das aufgeschmolzene Material von einer Oberfläche des Substrats ausgehend, gerichtet erstarrt und als epitaktische Schicht auf der Oberfläche des Substrats wächst.

Dieses bekannte Verfahren, dass sich bisher im Prinzip erfolgreich in der Praxis bewährt hat, ist jedoch in einem Punkt noch verbesserungsfähig. Bei dem bekannten Verfahren vollzieht sich der Prozess des Einkristallwachstums nämlich so, dass das aufgeschmolzene Material von allen (an den aufgeschmolzenen Bereich) angrenzenden Flächen ausgehend gerichtet erstarrt. Das heisst, dass verschiedene epitaktische Wachstumsbereiche, die entsprechend den angrenzenden Flächen der Oberfläche des Substrats, unter einem gewissen Winkel zueinander orientiert sein können, entstehen können. Ein solches Wachstum wird im Rahmen dieser Anmeldung als "mehrachsiges Wachstum" bezeichnet. In analoger Weise wird der Begriff "einachsiges Wachstum" verwendet. Diese verschieden orientierten Wachstumsbereiche können dann an einer oder mehreren Grenzflächen aufeinandertreffen, an welchen Grenzflächen sich dann Korngrenzen ausbilden können. Solche Korngrenzen zwischen unterschiedlich zueinander orientierten Wachstumsflächen treten daher insbesondere dann auf, wenn die Oberfläche an abgesetzten Stufen, Nuten oder Einbuchten des einkristallinen Substrats rekonstruiert wird. Auch beim Auftrag grossflächiger Schichten auf das einkristalline Substrat können Probleme der zuvor geschilderten Art auftreten. In der Praxis wird der Energiestrahl mit einer vorgebbaren Geschwindigkeit über das Substrat geführt, so dass schmale Bereiche in Form von Bahnen, ungefähr von der Breite des Laserstrahls, entstehen. Um grossflächige Schichten aufzubringen müssen somit sukzessiv mehrere parallele, unmittelbar nebeneinander angrenzende Bahnen mittels des Laserstrahl auf der Oberfläche des Substrats erzeugt werden, so dass man bei der Aufbringung jeder weiteren Bahn (entlang einer zuvor gelegten Bahn) mit einer stufenförmigen Struktur konfrontiert ist, die ein epitaktisches Wachstum, gleichzeitig in verschiedene Richtungen, begünstigt.

Die Aufgabe der Erfindung ist es daher, ein verbessertes Verfahren zum Einkristallschweissen auf einkristallinen Oberflächen vorzuschlagen, bei welchem die Entstehung von Korngrenzen in den neu erzeugten einkristallinen Bereichen, bis auf Kleinwinkelkorngrenzen, verhindert wird.

Das diese Aufgabe lösende erfindungsgemässe Verfahren ist durch die Merkmale des unabhängigen Anspruchs 1 gekennzeichnet. Die jeweiligen abhängigen Ansprüche beziehen sich auf besonders vorteilhafte Ausführungsformen des erfindungsgemässen Verfahrens.

Es wird somit erfindungsgemäss ein Verfahren zum Einkristallschweissen zur Erzeugung eines einkristallinen Bereichs auf einer Oberfläche eines einkristallinen Substrats mittels eines Energiestrahls vorgeschlagen. Das Verfahren zum Einkristallschweissen umfasst die Zuführung eines Beschichtungsmaterials, die Bildung einer Schmelze durch Aufschmelzen des Beschichtungsmaterials mittels des Energiestrahls, sowie das Aufschmelzen einer Oberflächenschicht des einkristallinen Substrats durch den Energiestrahl. Die Charakteristik der Energieverteilung im Energiestrahl wird dabei so eingestellt, dass der laterale Wärmefluss aus der Schmelze in das einkristalline Substrat minimiert wird.

Bevorzugt kommt das erfindungsgemässe Verfahren zum Einkristallschweissen zur Rekonstruktion der Oberfläche eines einkristallinen Substrats, dessen Oberfläche in Form von abgesetzten Stufen, Nuten, Einbuchten oder in anderer Weise beschädigt oder abgenutzt ist, zum Einsatz. Dabei wird auf dem Substrat Schicht um Schicht einkristallin auf und /oder weitergebaut bis die ursprüngliche Grösse und Form des Werkstücks wieder erreicht ist, wobei durch die Verwendung des erfindungsgemässen Verfahrens zum Einkristallschweissen in den rekonstruierten Bereichen das Auftreten von Korngrenzen, bis auf Kleinwinkelkorngrenzen, verhindert wird.

Bei dem erfindungsgemässen Verfahren wird ein Energiestrahl, z.B. ein Laserstrahl oder ein Elektronenstrahl auf die Oberfläche des Substrats gerichtet und in einer vorgebbaren Richtung über die Oberfläche geführt, so dass eine Oberflächenschicht des Substrats angeschmolzen wird. Im folgenden wird der Bereich, in dem der Energiestrahl unmittelbar seine Wirkung entfaltet, als Arbeitsbereich bezeichnet. Dem Arbeitsbereich wird von einer Zuführeinrichtung Beschichtungsmaterial z.B. in Form von Pulver oder in Form eines Drahtes oder anders zugeführt, so dass das Beschichtungsmaterial ebenfalls aufgeschmolzen wird. Bevorzugt erlaubt die Zuführeinrichtung das Beschichtungsmaterial in vorgebbaren Mengen, also dosiert dem Arbeitsbereich zuzuführen. Das Schmelzen des zugeführten Beschichtungsmaterials kann dabei entweder im Flüssigbad der geschmolzenen Oberflächenschicht des Substrats oder bereits auf dem Weg zum Arbeitsbereich oder gleichzeitig mit dem Aufschmelzen der Oberfläche erfolgen. Bei einem bevorzugten Ausführungsbeispiel des erfindungsgemässen Verfahrens wird die Charakteristik der Energieverteilung im Energiestrahl so eingestellt, dass zum Beispiel im Zentrum des Energiestrahls, der bevorzugt auf den zu schmelzenden Bereich des Arbeitsbereiches gerichtet wird, ein ausgeprägtes Energiemaximum vorliegt, so dass in diesem Bereich Substrat und Beschichtungsmaterial aufgeschmolzen werden kann. Ausserhalb des Energiemaximums fällt die Energieverteilung im Energiestrahl dann zunächst auf einen Wert ab, der nicht mehr geeignet ist Substrat und Beschichtungsmaterial zu schmelzen, jedoch das an die Schmelze angrenzende Material immer noch bis knapp unter die Schmelztemperatur aufheizen kann. Dadurch wird erreicht, dass zwischen Schmelze und angrenzendem festen Material ein lateraler Temperaturgradient derart minimiert wird, dass in lateraler Richtung ein Kristallwachstum unterbunden wird. Das Kristallwachstum findet somit nur noch in einer Richtung, in der Regel in einer zu der lateralen Richtung und zur Richtung der Führung des Energiestrahls senkrechten Richtung statt. Damit wird das Auftreten von Korngrenzen verhindert. Es sei noch erwähnt, dass die im Energiestrahl einstellbare Charakteristik der Energieverteilung je nach Anforderung auch eine andere Symmetrie aufweisen kann, als die oben beschriebene. Beispielsweise kann das Energiemaximum auch am Rand des Energiestrahls liegen, oder innerhalb des Energiestrahls, z.B. durch Überlagerung von zwei oder mehreren Einzelstrahlen, die aus einer oder mehreren verschiedenen Energiequellen stammen können, eine keulenförmige Charakteristik aufweisen oder jede andere geeignete Charakteristik aufweisen. Ausser durch Überlagerung mehrerer Einzelstrahlen kann die Charakteristik der Energieverteilung im Energiestrahl auch durch geeignete Einrichtungen, z.B. optische, magnetische oder andere Linsensysteme oder auf andere Art und Weise, durch Veränderung eines einzelnen Energiestrahls eingestellt werden.

Die laterale Richtung ist im Rahmen dieser Anmeldung stets diejenige Richtung, die senkrecht auf der Richtung der Bewegung des Energiestrahls steht und gleichzeitig in derjenigen Ebene liegt, in welcher der Energiestrahl bewegt wird.

Als Verfahren zur Energie- bzw. Wärmezufuhr kommen ausser der Verwendung der zuvor erwähnten Energiestrahlen auch Lichtbogenverfahren, wie z.B. Micro-TIG oder verschiedene Plasmaverfahren in Frage mit denen es möglich ist, im Energiestrahl eine vorgebbare Energieverteilung einzustellen. Je nach Anforderungen bzw. je nach Art der eingesetzten Energiequelle (Laserstrahlen, Elekronenstrahlen, Lichtbogenverfahren oder andere) wird der Beschichtungsvorgang unter Schutzgas oder im Vakuum in einer geeigneten Prozesskammer durchgeführt. Dabei ist auch denkbar, das Verfahren unter Umgebungsathmosphäre, also ohne Verwendung einer speziellen Prozesskammer, durchzuführen.

Die einkristalline Struktur wird bei dem erfindungsgemässen Verfahren in Form von dünnen Streifen, Schichten, Platten oder auch in komplexeren Formen aufgebaut. Dabei werden mehrere der dünnen Streifen, Schichten, Platten oder auch der komplexeren Formen, sukzessiv parallel, unmittelbar nebeneinander bzw. übereinander angrenzend auf das Substrat aufgebracht, wodurch die ursprüngliche Form des Substrats rekonstruiert werden kann.

In der Praxis wird der Energiestrahl in der Regel mittels einer programmierbaren Regel und / oder Steuereinheit über die Oberfläche des Substrats geführt. Dabei kann zusätzlich die Stärke der Energiequelle kontinuierlich den aktuellen Beschichtungsanforderungen angepasst, sowie die Charakteristik der Energieverteilung innerhalb des Energiestrahls auch während des Einkristallschweissens elektronisch programmierbar korrigiert und verändert werden.

Auf die Problematik und die Gesetzmässigkeiten des epitaktischen Kristallwachstums, das Auftreten von Dendriten und damit zusammenhängende Fragestellungen (z.B. GN-Diagramm) braucht an dieser Stelle nicht näher eingegangen zu werden, da diese dem Fachmann seit langem wohlbekannt sind. Dazu sei z.B. auf die EP 0 861 927 A1 und die darin zitierte Literatur verwiesen.

Zur Vermeidung bzw. Verringerung von inneren Spannungen im Substrat und / oder in den aufgebrachten einkristallinen Schichten, bzw. zwischen Substrat und aufgebrachten einkristallinen Schichten, kann das Substrat in speziellen Fällen, vorzugsweise induktiv aber auch auf andere Weise, auf eine Vorwärmtemperatur gebracht werden, die je nach Material, aus dem das Substrat bzw. das Beschichtungsmaterial aufgebaut ist, bevorzugt zwischen 750°C bis 1100°C liegen kann. Dadurch kann das epitaktische Wachstum der auf der Oberfläche aufzubauenden einkristallinen Strukturen zusätzlich begünstigt werden, indem beispielsweise Rekristallisation und / oder Kriechen in der Kristallstruktur verhindert oder zumindest minimiert wird. Unter Umständen kann es jedoch, um grössere Temperaturgradienten erzeugen zu können, durchaus vorteilhafter sein, mit deutlich niedrigeren Vorwärmtemperaturen, also bei Vorwärmtemperaturen unterhalb von 750°C und sogar ganz ohne Vorwärmen des Substrats zu arbeiten.

Obwohl das erfindungsgemässe Verfahren das Auftreten von Korngrenzen verhindert, kann dennoch das Auftreten von Kleinwinkelkorngrenzen nicht gänzlich ausgeschlossen werden. Daher kann es vorteilhaft sein, durch Entspannungsglühen von Substrat und neu aufgebauter Einkristallschicht, z.B. für den Zeitraum einer halben Stunde, einer Stunde, zwei Stunden oder länger im Temperaturbereich von 700°C bis 1250°C, bevorzugt bei etwa 1100°C, und nachfolgendem langsamem Abkühlen innere Eigenspannungen zu reduzieren und Kleinwinkelkorngrenzen abzubauen. Als Wärmequelle für das Entspannungsglühen kommen z.B. Hochfrequenz-Einrichtungen oder andere, z.B. konventionelle Wärmequellen in Frage. Dabei hängen die konkreten Behandlungsparameter, wie Aufheizrate, Temperatur, Zeitdauer des Entspannungsglühens, Abkühlrate nach dem Entspannungsglühen usw. unter anderem von den Materialien ab, aus denen das Substrat bzw. das Beschichtungsmaterial aufgebaut ist. Für CMSX-4 hat sich beispielsweise ein Entspannungsglühen für ca. eine Stunde bei einer Temperatur von ca. 1150°C mit nachfolgend langsamen Abkühlen bewährt.

Die Erfindung wird im Folgenden anhand der Zeichnung näher erläutert. Zur Unterscheidung des Standes der Technik von dem erfindungsgemässen Verfahren zum Einkristallschweissen sind die Bezugszeichen, die sich auf Merkmale aus dem Stand der Technik beziehen, mit Hochkomma versehen. Es zeigen in schematischer Darstellung:
- Fig. 1: ein Ausführungsbeispiel für die Anordnung von Energiestrahl, Zuführeinrichtung und zu beschichtendem Substrat bei Verwendung des erfindungsgemässen, sowie des bekannten Verfahrens;
- Fig. 2: mehrachsig generiertes Kristallwachstum an einer Oberfläche eines einkristallinen Substrats nach einem Verfahren aus dem Stand der Technik;
- Fig. 3: ein Ausführungsbeispiel für ein nach dem erfindungsgemässen Verfahren generiertes einachsiges Kristallwachstum an einer Oberfläche eines einkristallinen Substrats;
- Fig. 4: ein Beispiel für die Wachstumskinetik gemäss Fig. 2;

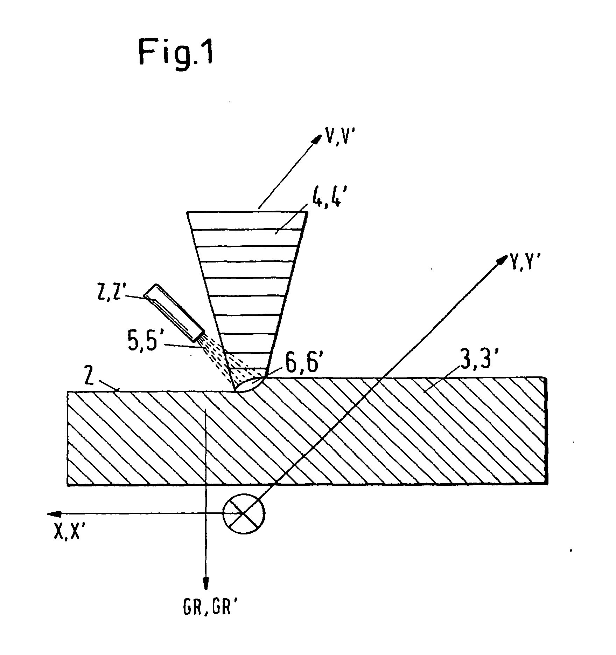

Fig. 1 zeigt schematisch ein Ausführungsbeispiel für die Anordnung von Energiestrahl 4, 4', Zuführeinrichtung Z, Z' und zu beschichtetendem Substrat 3, 3' bei Verwendung des erfindungsgemässen, sowie des bekannten Verfahrens. Wie bereits erwähnt beziehen sich im folgende diejenigen Bezugszeichen, die mit einem Hochkomma versehen sind, stets auf Merkmale, die aus dem Stand der Technik bereits bekannt sind. Fig. 1 zeigt ein einkristallines Substrat 3, 3', das eine in Form einer Stufe beschädigte Oberfläche aufweist. Der Energiestrahl, z.B. ein Laserstrahl, 4, 4' ist auf die Umgebung in der Nähe der Stufe gerichtet. Durch die Zuführeinrichtung Z, Z' wird dem Arbeitsbereich des Energiestrahls Beschichtungsmaterial 5, 5' zugeführt. Der Energiestrahl 4, 4' bildet so auf der Oberfläche eine Schmelze 6, 6', wobei der Energiestrahl 4, 4' in Richtung Y, Y' mit einer einstellbaren Geschwindigkeit V, V' entlang der Stufe über das Substrat 3, 3' bewegt werden kann. Das Substrat 3, 3' kann auf eine bestimmte Vorwärmtemperatur vorgeheizt werden, wobei zusätzlich senkrecht zur lateralen Richtung X, X' und senkrecht zur Richtung Y, Y' der Bewegung des Energiestrahls ein Temperaturgradient GR, GR' angelegt werden kann, um ein einkristallines Wachstum aus der Schmelze 6, 6' in entgegengesetzter Richtung zum Temperaturgradienten GR, GR' zu generieren.

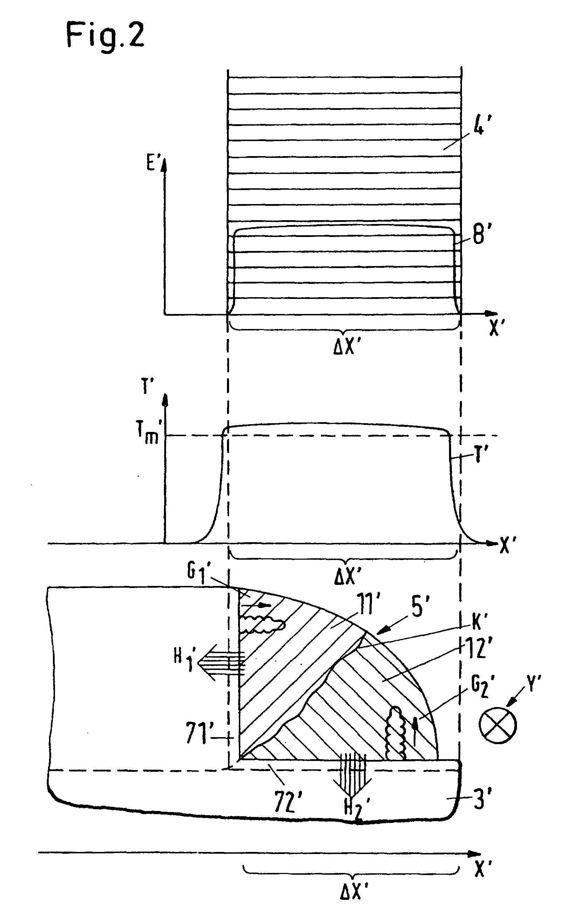

Fig. 2 demonstriert in einer schematischen Darstellung ein mehrachsig generiertes Kristallwachstum unter Bildung eines einkristallinen Bereichs 11' und 12' an einer stufenartigen Struktur auf einem einkristallinen Substrat 3', wie es typischerweise beim Einkristallschweissen nach dem aus dem Stand der Technik bekannten Verfahren generiert wird.

Ein Laserstrahl 4', der über einen Querschnitt ΔX' eine im wesentlichen konstante Charakteristik 8' einer Energieverteilung aufweist, wird auf einen Oberflächenbereich, der im wesentlichen die gleiche Abmessung ΔX' wie der Laserstrahl 4' aufweist, auf das Substrat 3' gerichtet. Im Bereich ΔX' auf der Oberfläche des Substrats 3' werden das Beschichtungsmaterial 5', sowie die Oberflächenschichten 71' und 72' des Substrats 3' aufgeschmolzen.

Zur Beschichtung wird der Laserstrahl 4' gemäss Fig. 1 mit einer vorgebbaren Geschwindigkeit V' unter ständiger Zufuhr von neuem Beschichtungsmaterial 5' über die Oberfläche des Substrats 3' in Richtung Y' bewegt. Bedingt durch die im wesentlichen rechteckförmige Chararakteristik 8' der Energieverteilung im Laserstrahl 4' ergibt sich in der lateralen Richtung X' ein Temperaturverlauf T', der in der Schmelze 6' des Beschichtungsmaterials 5' einen weitgehend konstanten Temperaturwert oberhalb der Schmelztemperatur Tₘ' zeigt und der in einer Oberflächenschicht 71' des Substrats derart auf einen Temperaturwert unterhalb der Schmelztemperatur Tₘ' abfällt, dass in der lateralen Richtung X' ein so grosser Temperaturgradient entsteht, dass pro Zeiteinheit ein entsprechender lateraler Wärmefluss H₁' entsteht. Der laterale Wärmefluss H₁' entzieht der Schmelze 6' soviel Wärmeenergie, dass ein Kristallwachstum im Bereich 11' mit einer Kristallwachstumsgeschwindigkeit G₁' in lateraler Richtung X' vom Rand der Schmelze 6' her generiert wird. Der analoge Vorgang spielt sich an der zur Oberfläche 71' nicht parallelen Oberflächenschicht 72' ab, über die ein weiterer Wärmeabfluss H₂' erfolgt, so dass auch im Bereich 12' senkrecht zur Oberflächenschicht 72' ein Kristallwachstum mit einer anderen Kristallwachstumsgeschwindigkeit G₂' generiert wird. Die beiden Wachstumsbereiche 11' und 12' bilden dann aufgrund der unterschiedlichen Kristallwachstumsrichtungen eine oder mehrere gemeinsame Korngrenzen K', die letztlich zu einer Verschlechterung der mechanischen, thermischen oder weiterer Eigenschaften der Oberflächenschicht im Betrieb des reparierten Werkstücks führt.

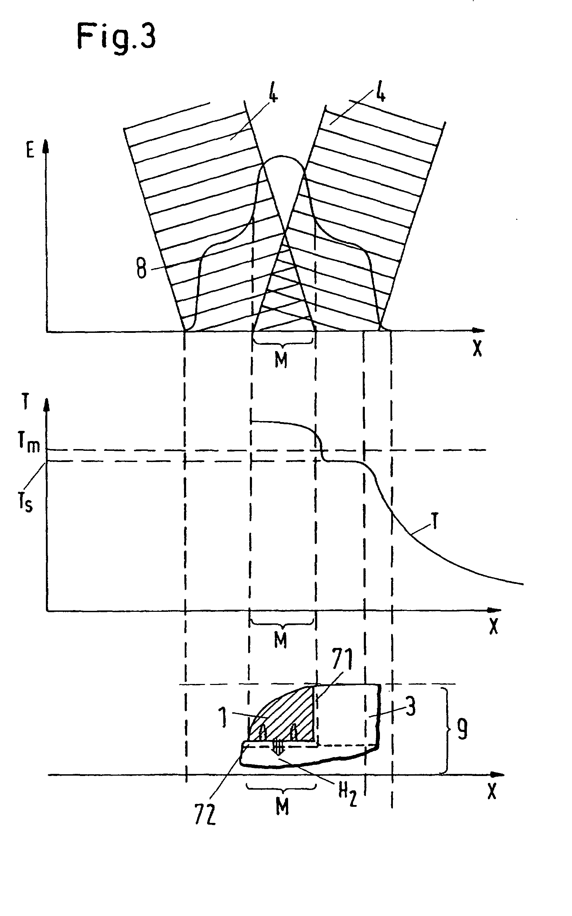

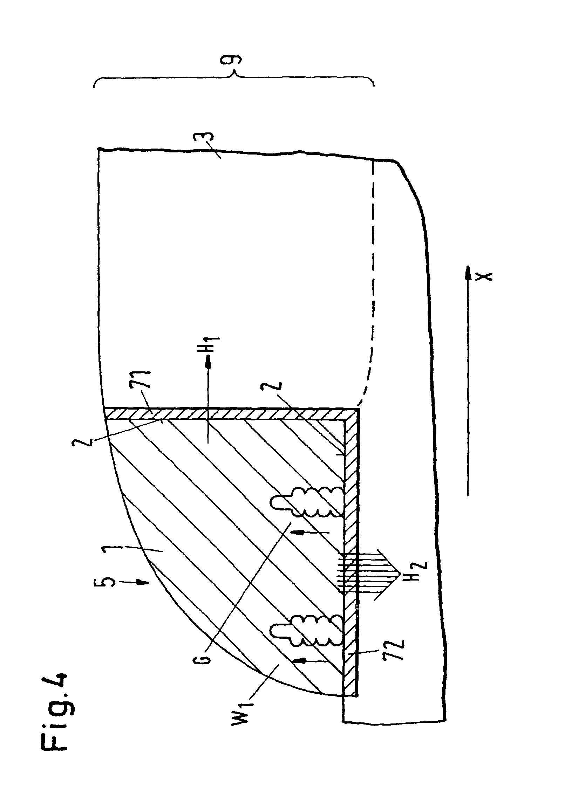

In den Fig. 3 und 4 wird in schematischer Darstellung das erfindungsgemässe Verfahren zum Einkristallschweissen illustriert. Das Substrat und / oder das Beschichtungsmaterial umfasst bevorzugt sogenannte Superlegierungen wie z.B. IN 738LC, IN 939, IN 100, B 1914, CM 99, SRR 99, CM-247 LC, CMSX-2, CMSX-3, CMSX-4, CMSX-6, Mar-M002 oder andere Superlegierungen bzw. andere geeignete Werkstoffe. In dem hier gezeigten bevorzugten Ausführungsbeispiel werden zwei Energiestrahlen, z.B. zwei Laserstrahlen, in einem Schmelzbereich M in der Nähe der zu schmelzenden Oberfläche 2 des Substrats 3 teilweise zur Deckung gebracht. Das hat zur Folge, dass die Charakteristik 8 der Energieverteilung im Energiestrahl im Schmelzbereich M ein ausgeprägtes Maximum aufweist. Ausserhalb des Schmelzbereichs M fällt die Charakteristik 8 der Energieverteilung dann zunächst auf einen Wert ab, der dem Energieinhalt eines einzelnen Energiestrahls entspricht, um schliesslich in einem Bereich ausserhalb des Energiestrahls auf den Energiewert null abzufallen. Ein entsprechender lateraler Temperaturverlauf T ergibt sich in der Schmelze 6 bzw. in der Oberfläche des Substrats 3. Im Bereich M, indem sich das Beschichtungsmaterial 5 befindet und in den an den Bereich M angrenzenden Oberflächenschichten 71 und 72 des Substrats 3, herrscht unter dem Einfluss des Energiestrahls 4 eine Temperatur, die höher als die Schmelztemperatur Tₘ des Substrats 3 und des Beschichtungsmaterials 5 ist. Dabei wird der Energiestrahl so ausgerichtet und eingestellt, dass lediglich eine dünne Randschicht 71 und 72 des Substrats 3 aufgeschmolzen wird. In der lateralen Richtung X fällt die Temperatur innerhalb des Substrats 3 dann zunächst auf einen konstanten Wert Tₛ unterhalb der Schmelztemperatur ab, so dass in lateraler Richtung angrenzend zur Schmelze 6 und innerhalb des Substrats 3 ein Bereich von im wesentlichen konstanter Temperatur Tₛ vorliegt, wobei die Temperatur Tₛ so dicht unterhalb der Schmelztemperatur Tₘ liegt, dass in lateraler Richtung zwischen Schmelze 6 und dem unmittelbar daran angrenzenden Substrat 3 ein Wärmefluss H₁ soweit minimiert wird, dass ein Kristallwachstum in lateraler Richtung praktisch unterbunden wird. Dagegen wird zwischen Schmelze 6 (an der zur Oberfläche 71 nicht parallelen Oberflächenschicht 72) und dem angrenzenden Substrat 3 ein entsprechend hoher Temperaturgradient, z.B. durch Kühlung des Substrats so eingestellt, dass ein Wärmeabfluss H₂ in das Substrat entsteht. Dadurch wird schliesslich senkrecht zur Oberflächenschicht 72 ein Kristallwachstum mit einer Kristallwachstumsgeschwindigkeit G generiert.

Durch Einsatz des erfindungsgemässen Verfahrens zum Einkristallschweissen wird die Entstehung mehrerer verschieden orientierter Kristallwachstumsgebiete 11' und 12', wie sie zwangsläufig bei dem aus dem Stand der Technik bekannten Verfahren auftreten, unterbunden und somit die Bildung von Korngrenzen K', bis auf Kleinwinkelkorngrenzen verhindert. Dadurch wird die Qualität von Werkstücken, deren Oberflächen durch das erfindungsgemässe Verfahren rekonditioniert werden, im Vergleich zu Werkstücken, die nach dem aus dem Stand der Technik bekannten Verfahren behandelt wurden, deutlich erhöht. Insbesondere für die Reparatur von Maschinenteilen, die in Bereichen zum Einsatz kommen, in denen die Betriebssicherheit thermisch und mechanisch hoch belasteter Komponenten von entscheidender Bedeutung ist, wie beispielsweise im Flugzeugbau, stellt die Verwendung des erfindungsgemässen Verfahrens einen bedeutenden Fortschritt dar.

## Patentansprüche

1. Verfahren zum Einkristallschweissen zur Erzeugung eines einkristallinen Bereichs (1) auf einer Oberfläche (2) eines einkristallinen Substrats (3) mittels eines Energiestrahls (4), umfassend:
- die Zuführung eines Beschichtungsmaterials (5),
- die Bildung einer Schmelze (6) durch Aufschmelzen des Beschichtungsmaterials (5) mittels des Energiestrahl (4),
- und das Aufschmelzen einer Oberflächenschicht (71, 72) des einkristallinen Substrats (3) durch den Energiestrahl (4),
**dadurch gekennzeichnet, dass** die Charakteristik (8) der Energieverteilung im Energiestrahl (4) so eingestellt wird, dass der laterale Wärmefluss (H₁) aus der Schmelze (6) in das einkristalline Substrat (3) minimiert wird.

2. Verfahren nach Anspruch 1, wobei ein Wachstum des einkristallinen Bereichs (1) auf dem Substrat (3) im wesentlichen nur in einer vorgebbaren Richtung (W₁) generiert wird.

3. Verfahren nach Anspruch 1 oder 2, bei welchem als Energiestrahl (4) mindestens ein Laserstrahl verwendet wird.

4. Verfahren nach einem der vorangehenden Ansprüche, bei welchem mindestens zwei Energiestrahlen (4), vorzugsweise mindestens zwei Laserstrahlen, verwendet werden.

5. Verfahren nach einem der vorangehenden Ansprüche, wobei der einkristalline Bereich (1) entlang einer abgesetzten Stufe oder einer Nut oder einer Einbuchtung an oder in der Oberfläche (2) des einkristallinen Substrats (3) erzeugt wird.

6. Verfahren nach einem der vorangehenden Ansprüche, bei welchem das Substrat (3) auf eine Vorwärmtemperatur, vorzugsweise im Temperaturbereich von 800°C bis 1000°C vorgewärmt wird, wobei die Vorwärmtemperatur während des Herstellens des einkristallinen Bereichs (1) vorzugsweise konstant gehalten wird.

7. Verfahren nach Anspruch 6, bei welchem das Vorwärmen induktiv erfolgt.

8. Verfahren nach einem der vorangehenden Ansprüche, bei welchem das Substrat (3) und / oder das Beschichtungsmaterial (5) eine metallische Superlegierung, beispielsweise auf Kobalt-Basis oder auf Eisen-Basis oder auf Nickel-Basis, wie beispielsweise IN 738LC, IN 939, IN 100, B 1914, CM 99, SRR 99, CM-247 LC, CMSX-2, CMSX-3, CMSX-4, CMSX-6, Mar-M002 oder andere Superlegierungen umfasst.

9. Verfahren nach einem der vorangehenden Ansprüche, bei welchem der hergestellte einkristalline Bereich (1) nach dem Einkristallschweissen, vorzugsweise bei einer Temperatur im Bereich von 1000°C bis 1250°C, vorzugsweise bei etwa 1150°C, spannungsarmgeglüht wird.

10. Verwendung des Verfahrens nach einem der Ansprüche 1 bis 9 zum Ergänzen einer einkristallinen Oberflächenstruktur eines abgenutzten einkristallinen Substrats (3), insbesondere einer abgenutzten einkristallinen Turbinenschaufel, wie beispielsweise der Rotorschaufel einer Gasturbine oder eines Flugzeugtriebwerks.

## Claims

1. A method of single crystal welding for the production of a single crystal region (1) on a surface (2) of a monocrystalline substrate (3) by means of an energy beam (4), including:
- the supply of a coating material (5);
- the formation of a melt (6) by melting the coating material (5) by means of the energy beam (4);
- and the melting of a surface layer (71, 72) of the single crystal substrate (3) by the energy beam (4);
**characterised in that** the characteristic (8) of the energy distribution in the energy beam (4) is set such that the lateral thermal flow (Hi) from the melt (6) into the single crystal substrate (3) is minimised.

2. A method in accordance with claim 1, wherein a growth of the single crystal region (1) on the substrate (3) is substantially only generated in a pre-settable direction (W₁).

3. A method in accordance with claim 1 or claim 2, in which at least one laser beam is used as the energy beam (4).

4. A method in accordance with any one of the preceding claims, in which at least two energy beams (4), preferably at least two laser beams, are used.

5. A method in accordance with any one of the preceding claims, wherein the single crystal region (1) is produced along a stepped shoulder or a groove or a depression at or in the surface (2) of the single crystal substrate (3).

6. A method in accordance with any one of the preceding claims, in which the substrate (3) is pre-heated to a pre-heat temperature, preferably in the temperature range from 800°C to 1000°C, with the pre-heat temperature preferably being kept constant during the manufacture of the single crystal region (1).

7. A method in accordance with claim 6, in which the pre-heating takes place inductively.

8. A method in accordance with any one of the preceding claims, in which the substrate (3) and/or the coating material (5) includes a metallic supper alloy, for example on a cobalt base or on an iron base or on a nickel base, such as IN 738LC, IN 939, IN 100, B 1914, CM 99, SRR 99, CM-247 LC, CMSX-2, CMSX-3, CMSX-4, CMSX-6, Mar-M002 or other super alloys.

9. A method in accordance with any one of the preceding claims, in which the produced single crystal region (1) is annealed at low stress after the single crystal welding, preferably at a temperature in the range from 1000°C to 1250°C, preferably at approximately 1150°C.

10. Use of a method in accordance with any one of claims 1 to 9 to supplement a single crystal surface structure (3), in particular a worn single crystal turbine blade such as the rotor blade of a gas turbine or of an aeroplane engine.

## Revendications

1. Procédé de soudage monocristallin pour produire une zone monocristalline (1) sur une surface (2) d'un support monocristallin (3) au moyen d'un faisceau d'énergie (4), comprenant:
- l'amenée d'un matériau de revêtement (5),
- la réalisation d'une fonte (6) en faisant fondre le matériau de revêtement (5) au moyen du faisceau d'énergie (4),
- et la fusion d'une couche de surface (71, 72) du support monocristallin (3) par le faisceau d'énergie (4),
**caractérisé en ce que** la caractéristique (8). de la répartition de l'énergie dans le faisceau d'énergie (4) est réglée de façon que le flux de chaleur latéral (H₁) de la fonte (6) dans le substrat monocristallin (3) soit réduit à un minimum.

2. Procédé selon la revendication 1, où est générée une croissance de la zone monocristalline (1) sur le substrat (3) essentiellement seulement dans une direction prédéfinissable (W₁).

3. Procédé selon la revendication 1 ou 2, où au moins un faisceau laser est utilisé comme faisceau d'énergie (4).

4. Procédé selon l'une des revendications précédentes, dans lequel au moins deux faisceaux d'énergie (4), de préférence au moins deux faisceaux lasers, sont utilisés.

5. Procédé selon l'une des revendications précédentes, où la zone monocristalline (1) est produite le long d'un gradin étagé ou d'une rainure ou d'un creux à ou dans la surface (2) du support monocristallin (3).

6. Procédé selon l'une des revendications précédentes, dans lequel le support (3) est préchauffé à une température de préchauffage, de préférence dans la gamme de températures de 800°C à 1000°C, où la température de préchauffage est maintenue de préférence constante pendant l'établissement de la zone monocristalline (1).

7. Procédé selon la revendication 6, où le préchauffage a lieu d'une manière inductive.

8. Procédé selon l'une des revendications précédentes, où le support (3) et/ou le matériau de revêtement (5) comprend un super-alliage métallique, par exemple à base de cobalt ou à base de fer ou à base de nickel, comme par exemple IN 738LC, IN 939, IN 100, B 1914, CM 99, SRR 99, CM-247 LC, CMSX-2, CMSX-3; CMSX-4, CMSX-6, Mar-MOO2 ou bien d'autres super-alliages.

9. Procédé selon l'une des revendications précédentes, où la zone monocristalline réalisée (1), après le soudage monocristallin, est soumise à un recuit pauvre en tension, de préférence à une température dans la plage de 1000°C à 1250°C, de préférence à environ 1150°C.

10. Utilisation du procédé selon l'une des revendications 1 à 9 pour compléter une structure de surface monocristalline d'un support monocristallin usé (3), en particulier d'une aube de turbine monocristalline usée, comme par exemple, de la pâle de rotor d'une turbine à gaz ou d'un mécanisme d'entraînement d'avion.
